# EUROPÄISCHE PATENTSCHRIFT

(11) **EP 3 226 017 B1**
(45) Veröffentlichungstag und Bekanntmachung des Hinweises auf die Patenterteilung: **24.10.2018**
(21) Anmeldenummer: 16163257.5
(22) Anmeldetag: 31.03.2016
(51) Int. Cl.: G01R 33/00

(54) **DETEKTION EINES ÖFFNUNGSVORGANGES EINER ABDECKVORRICHTUNG**
DETECTION OF AN OPENING PROCESS OF A COVERING DEVICE
DETECTION D'UN PROCESSUS D'OUVERTURE D'UN DISPOSITIF DE RECOUVREMENT

(43) Veröffentlichungstag der Anmeldung: 04.10.2017
(73) Patentinhaber: Siemens Aktiengesellschaft, 80333 München (DE)
(72) Erfinder: Oechsle, Walter, 90766 Fürth (DE); Stecher, Werner, 91183 Abenberg (DE); Wolf, Stefan, 91074 Herzogenaurach (DE)

(56) Entgegenhaltungen:
- WO-A2-2007/124129
- US-A1- 2007 188 933
- US-A1- 2008 054 895

## Beschreibung

Die Erfindung betrifft eine Vorrichtung zur Detektion eines Öffnungsvorganges einer Abdeckvorrichtung, wobei die Abdeckvorrichtung zum Abdecken einer Öffnung eines Gehäuses ausgebildet ist und wobei das Gehäuse zur Aufnahme der Vorrichtung und eines elektrischen Geräts ausgebildet ist. Des Weiteren betrifft die Erfindung ein elektrisches Gerät, das zur Aufnahme im Gehäuse ausgebildet ist.
Eine derartige Vorrichtung kann zum Schutz von sensiblen elektrischen Geräten vor Manipulationen eingesetzt werden. Dies ist beispielsweise bei sicheren Arbeitsplatzrechnern oder weiteren Computern der Fall, ist aber ebenso in weiteren Gebieten wie bei Bankautomaten oder Empfängern für verschlüsselte Signale, insbesondere verschlüsselte Satellitensignale, anwendbar.
Aus WO 2007/124129 A2 ist eine manipulationsfeststellende Gehäuseanordnung für einen umschlossenen Raum, die einen Innenraum enthält, in dem ein geschütztes Objekt positioniert ist, bekannt. Dabei kommt ein magnetoresistiver Magnetspeicher zum Einsatz, der gegenüber einem extern anliegenden Magnetfeld empfindlich ist. Der Magnetspeicher verändert seinen magnetischen Zustand messbar, wenn in das Gehäuse eingedrungen wurde.

Eine ähnliche Vorrichtung ist aus der US2008/054895 bekannt.

Die Aufgabe der vorliegenden Erfindung ist es, eine Vorrichtung der eingangs genannten Art zur Verfügung zu stellen, die eine zuverlässige Erkennung eines Öffnungsvorgangs ermöglicht.
Die Aufgabe wird durch eine Vorrichtung mit den im Anspruch 1 angegebenen Merkmalen gelöst. Dabei weist die Vorrichtung eine Magnetanordnung und eine Magnetfeldsensoranordnung auf. Die Magnetanordnung weist mindestens einen Permanentmagnet und die Magnetfeldsensoranordnung weist mindestens einen Magnetfeldsensor auf. Die Magnetanordnung und/oder die Magnetfeldsensoranordnung sind jeweils derart an der Abdeckvorrichtung und/oder dem Gehäuse angebracht, dass der Öffnungsvorgang von der Magnetsensoranordnung erfassbar ist. Der Magnetfeldsensor ist dabei zur Erfassung der Richtung von Magnetfeldern ausgebildet.

Die Abdeckvorrichtung kann dabei eine Abdeckung, ein Deckel, eine Klappe eines Gehäuses oder einfach ein Teil eines zweigeteilten Gehäuses sein, die jeweils zusammen ein geschlossene Einheit ergeben. Jegliche weitere Kombinationen die zusammen eine geschlossene Einheit ergeben sind ebenfalls denkbar. Die Abdeckvorrichtung und das Gehäuse sind zumindest teilweise voneinander trennbar ausgeführt.

Die Öffnung kann dabei z.B. die Öffnung des Gehäuses sein, die durch Entfernen der Abdeckvorrichtung entsteht. Das Gehäuse ist ein Gehäuse, das zur Aufnahme eines elektrischen Gerätes ausgebildet ist und mit der Abdeckvorrichtung verschließbar ist. Die Vorrichtung soll nun jegliche Öffnungsvorgänge der Abdeckvorrichtung gegenüber dem Gehäuse detektieren können. Die Magnetanordnung kann dabei beispielsweise in der Abdeckvorrichtung angebracht sein und die einzelnen Magnete der Magnetanordnung können sich an verschiedenen Orten der Abdeckvorrichtung finden. Die Magnetfeldsensoranordnung erfasst in geschlossenem Zustand beispielsweise das Magnetfeld der einzelnen Magnete und damit kann festgestellt werden, dass das Gehäuse geschlossen ist. Die Magnetfeldsensoranordnung kann dabei aus mehreren Magnetfeldsensoren bestehen, wobei die Magnetfeldsensoren beispielsweise als GMR-Sensoren ausgebildet sein können. Je mehr Permanentmagnete die Magnetanordnung aufweist, desto mehr Kombinationsmöglichkeiten ergeben sich um eine einzigartige Magnetanordnung zu konstruieren. Die Abdeckvorrichtung sowie das Gehäuse können dabei beispielsweise aus Aluminium, insbesondere aus Duraluminium, bestehen das eine vernachlässigbare magnetische Beeinflussung aufweist. Mit der vorliegenden Erfindung ist es also vorteilhaft möglich, Zugriffe auf das Gehäuse zu erkennen und weitere Schritte als Reaktion auf den Zugriff durchzuführen. Diese Schritte können vom Dokumentieren des Öffnungsvorgangs selbst bis hin zu einer Zerstörung des elektrischen Gerätes oder dessen Daten reichen.

In einer weiteren Ausführungsform weist die Vorrichtung eine Magnetfeldführungsanordnung auf, die zur Führung des Magnetfeldes der Magnetanordnung in einen Erfassungsbereich der Magnetsensoranordnung im geschlossenen Zustand der Abdeckvorrichtung ausgebildet. Der Erfassungsbereich der Magnetsensoranordnung soll dabei der Bereich sein, in den das Magnetfeld der Magnetanordnung durch die Magnetfeldführungsanordnung im geschlossenen Zustand des Gehäuses geleitet wird. Je nach verwendetem Sensortyp sind hier entsprechende Toleranzen zulässig. Der Erfassungsbereich sollte dabei idealerweise so groß sein, dass die durch die Fertigung und Montage auftretenden Toleranzen kompensiert werden können, sollte aber andererseits so klein sein, dass eine Manipulation durch von außen angelegte Magnetfelder nicht möglich ist. Die Magnetfeldführungsanordnung erhöht die konstruktive Freiheit bei der Konstruktion des Gehäuses. Ziel der Magnetfeldführungsanordnung ist es, das Magnetfeld der Magnetanordnung bzw. der einzelnen Permanentmagnete im geschlossenen Zustand des Gehäuses so an die Magnetfeldsensoranordnung heranzuführen, dass erstens eine Manipulation von außen nur erschwert möglich ist und zweitens auch die konstruktive Freiheit im Inneren des Gehäuses, insbesondere bezüglich der Positionierung der Magnetfeldsensoren, erhöht wird. Die Magnetfeldführungsanordnung besteht vorzugsweise aus einem weichmagnetischen Werkstoff, d.h. ferromagnetische Materialien mit hoher magnetischer Permeabilität und geringer Remanenz.

Ebenso möglich ist, dass die Magnetfeldführungsanordnung derart ausgebildet ist, dass sie einen Großteil des Abstands zwischen der Magnetanordnung und der Magnetsensoranordnung überbrückt. Dies ist insbesondere in großen Gehäusen von Vorteil. Ein Großteil kann dabei beispielsweise über die Hälfte der zu überbrückenden Gehäusedimension, wie beispielsweise die Gehäusehöhe, sein. Auf diese Art wird sichergestellt, dass die Abdeckvorrichtung auch bei entsprechend hohem Platzbedarf innerhalb des Gehäuses mit der Vorrichtung gesichert werden kann. Der hohe Platzbedarf ist nicht notwendigerweise auf ein besonders großes elektrisches Gerät zurückzuführen, sondern kann auch viele weitere Gründe haben. Hier wären beispielsweise vorgegebene Abstände des elektrischen Geräts von den Gehäusewänden, die Abschirmung von elektromagnetischer Strahlung von außerhalb des Gehäuses (Sicherheit gegenüber Beeinflussung von außen) und/oder von innerhalb des Gehäuses (Abhörsicherheit) oder die Dämpfung von mechanischen Einflüssen auf den Inhalt des Gehäuses zu nennen. In diesen und weiteren Fällen ist es vorteilhaft entsprechende Magnetfeldführungsanordnungen, die einen Großteil des Abstands zwischen der Magnetanordnung und der Magnetsensoranordnung überbrücken, vorzusehen. Beispielsweise können die Magnetfeldführungsanordnungen über 70% insbesondere über 90% des Abstandes überbrücken.

In einer weiteren Ausführungsform ist der Magnetfeldsensor zur Erfassung der Richtung von Magnetfeldern ausgebildet. Ist der Magnetfeldsensor nicht nur zur Erfassung einer Magnetfeldstärke bzw. einer Schwelle einer Magnetfeldstärke sondern auch zur Erfassung der Richtung von Magnetfeldern ausgebildet, so kann die Vorrichtung nicht nur erkennen ob die Magnetanordnungen, an den richtigen Stellen angebracht sind, sondern kann auch erkennen, ob die Magnete auch die richtige Ausrichtung ihrer Pole aufweisen. Die Magnete können z.B. an der Abdeckvorrichtung angebracht sein. Besonders vorteilhaft ist daran, dass so nicht nur die Stärke des Magnetfelds sondern auch die Richtung des Magnetfelds ausgewertet werden kann und so eine höhere Sicherheit gewährleistet werden kann.

In einer weiteren Ausführungsform weist die Magnetfeldsensoranordnung eine Schnittstelle zum elektrischen Gerät auf. Es ist denkbar, dass die Schnittstelle zum elektrischen Gerät dabei sowohl Daten als auch elektrische Leistung übertragen kann. Sind am elektrischen Gerät mehrere Anschlüsse für solche Schnittstellen der Magnetfeldsensoranordnung vorgesehen und sind diese so ausgebildet, dass die Magnetsensoranordnung bei der Montage einfach ausgetauscht werden kann, so ist es denkbar, dass für jede Magnetanordnung auch eigens eine Magnetfeldsensoranordnung bereitgestellt wird. Diese eigens bereitgestellten Magnetfeldsensoranordnungen können dann jeweils auf die genaue Art und Weise der Anbringung der Magnetanordnung abgestimmt werden. Dies ermöglicht eine enorm flexible Produktion einer solchen Vorrichtung, und erhöht die Sicherheit durch Trennung der Produktion der sicherheitsrelevanten Bauteile vom restlichen Gerät weiter.
In einer weiteren Ausführungsform ist die Magnetfeldsensoranordnung ein Teil des elektrischen Geräts. Es ist denkbar, dass die Magnetfeldsensoranordnung als ein Teil des elektrischen Geräts ausgebildet ist und dort bereits bei der Konstruktion berücksichtigt wird. Dies ist zwar weniger flexibel, kann aber bei einer potentiellen Massenproduktion deutlich günstiger gefertigt werden. Auch hier kann eine interne Schnittstelle den Datentransfer sicherstellen und elektrische Leistung zur Verfügung stellen.
In einer weiteren Ausführungsform ist die Magnetfeldführungsanordnung als ein Teil der Abdeckvorrichtung ausgebildet. Die Abdeckvorrichtung kann bereits bei der Konstruktion so ausgebildet werden, dass die Magnetfeldführungsanordnung ein Teil der Abdeckvorrichtung ist. Dabei ist zu beachten, dass die Abdeckvorrichtung und die Magnetfeldführungsanordnung aus verschiedenen Materialien bestehen können.

Gemäß der Erfindung ist die Magnetfeldführungsanordnung als ein Befestigungsmittel ausgebildet, wobei das Befestigungsmittel zur Befestigung der Abdeckvorrichtung am Gehäuse vorgesehen ist. Die Befestigungsmittel können dabei Nieten, Bolzen, Schrauben, Nägel, Stifte oder weitere derartige Befestigungsmittel sein, die mit dem Verschließen des Gehäuses durch die Abdeckvorrichtung das Magnetfeld der Magnetanordnung an die Magnetfeldsensoranordnung weiterleiten. So kann gewährleistet werden, dass das Gehäuse, sobald es einmal ordnungsgemäß montiert wurde, nicht wieder geöffnet werden kann, ohne das Magnetfeld der Magnetanordnung zu beeinflussen. Sollte versucht werden, eines der Befestigungsmittel zu entfernen, also beispielsweise eine Schraube herauszudrehen, so wird dies direkt vom zugeordneten Magnetfeldsensor der zugeordneten Magnetfeldsensoranordnung erkannt und entsprechende Maßnahmen können getroffen werden. Diese Maßnahmen können dabei beispielsweise ein Sperren des elektrischen Geräts oder das Deaktivieren einzelner Funktionen sein.

In einer weiteren Ausführungsform sind die Befestigungsmittel derart ausgebildet, dass sie von außerhalb des Gehäuses nicht lösbar, insbesondere nicht zerstörungsfrei lösbar, sind. Dies hat den Vorteil, dass der Eindringschutz noch weiter verbessert wird. Beispielsweise können die Befestigungsmittel als Nieten, eingepresste Bolzen oder jegliche weitere Befestigungsmittel die beispielsweise verschweißt oder verlötet werden ausgebildet sein. Sollte nun eines der Befestigungsmittel durch herausgebohrt werden, so verändert sich sofort das an der Magnetfeldsensoranordnung anliegende Magnetfeld und der Versuch des Eindringens wird erkannt.

In einer weiteren Ausführungsform ist die Magnetfeldsensoranordnung zur Erfassung einer charakteristischen Magnetisierung der Magnetanordnung ausgebildet. Die charakteristische Magnetsierung soll dabei durch die Anordnung der einzelnen Permanentmagneten hervorgerufene Muster der magnetischen Feldstärke und -richtung sein, die durch die Magnetsensoranordnung erfasst und im Anschluss ausgewertet werden kann. Anhand der charakteristischen Magnetsierung kann also festgestellt werden, ob sich die richtige Abdeckvorrichtung auf dem Gehäuse befindet.

In einer weiteren Ausführungsform weist die Magnetfeldsensoranordnung eine Auswerteeinheit auf, die zur Auswertung der charakteristischen Magnetisierung und zur Weitergabe der charakteristischen Magnetisierung oder einer darauf basierenden Information an das elektrische Gerät über die Schnittstelle ausgebildet ist. Die charakteristische Magnetisierung kann also an das elektrische Gerät weitergegeben werden, um dort weiterverarbeitet zu werden. Die Schnittstelle kann dabei als sichere Schnittstelle mit einer verschlüsselten Übertragung ausgebildet sein, es können aber ebenso die Messwerte der Magnetfeldsensoren direkt übertragen werden. Je nach Ausprägung muss die Magnetfeldsensoranordnung entsprechende Auswerteelektronik aufweisen. Bei einer verschlüsselten Kommunikation ist es denkbar, dass sowohl das elektrische Gerät als auch die Magnetfeldsensoranordnung einen Kryptochip aufweisen, der eine verschlüsselte Verbindung ermöglicht.

In einer weiteren Ausführungsform weist die Magnetfeldsensoranordnung eine Auswerteeinheit auf, die zur Generierung eines Freischalt- und/oder Sperrsignals zur Freischaltung und/oder Sperrung von Funktionen des elektrischen Geräts ausgebildet ist. Die Auswerteeinheit kann dabei ein Mikrocontroller oder eine analoge Logik sein. Jegliche weitere Auswerteeinheiten, wie beispielsweise ein ASIC oder ein FPGA sind ebenso denkbar. Die Aufgabe der Auswerteeinheit ist es, die Signale der Magnetfeldsensoranordnung und damit der einzelnen Magnetfeldsensoren so auszuwerten, dass daraus auf den Zustand der Abdeckvorrichtung des Gehäuses geschlossen werden kann. Stellt die Auswerteeinheit nun fest, dass das Gehäuse ordnungsgemäß mit der Abdeckvorrichtung verschlossen ist, so kann ein Freischalt- und/oder ein Sperrsignal an das elektrische Gerät ausgegeben werden. Dabei können erweiterte Funktionen des Geräts freigeschaltet werden oder auch, falls ein eingeschränkter Betrieb des elektrischen Geräts ohne die Abdeckvorrichtung möglich ist, Funktionen deaktiviert werden. Analog können ebenfalls, wenn die Abdeckvorrichtung nicht ordnungsgemäß angebracht ist, entsprechende erweiterte Funktionen gesperrt werden.

Die Aufgabe wird weiterhin gelöst durch ein elektrisches Gerät, das zur Aufnahme in einem Gehäuse ausgebildet ist, und ferner eine Schnittstelle zu einer Vorrichtung aufweist. Als ein elektrisches Gerät kann dabei jegliches elektrische Gerät in Frage kommen, das vorteilhaft in einem geschützten Gehäuse betrieben werden soll. Dies können beispielsweise sichere PCs, Empfänger von verschlüsselten Signalen, Bankautomaten und viele weitere Geräte sein. Die Schnittstelle des elektrischen Geräts ist dabei so ausgebildet, dass sie mit einer Magnetfeldsensoranordnung und evtl. mit einer der Auswerteeinheiten kommunizieren kann.

In einer weiteren Ausführungsform weist das elektrische Gerät eine Auswerteeinheit auf, die zur Auswertung einer charakteristischen Magnetisierung und/oder eine auf der charakteristischen Magnetisierung basierenden weiteren Information ausgebildet ist. Werden über die Schnittstelle des elektrischen Geräts und die Schnittstelle der Magnetfeldsensoranordnung die Rohdaten der Magnetfeldsensoren übertragen, so ist es denkbar, dass das elektrische Gerät selbst eine Auswerteeinheit aufweist. Die Auswerteeinheit wertet die Sensorsignale aus und darauf basierend können weitere Aktionen durchgeführt werden. Bei einer Integration einer Auswerteeinheit in oder auf das elektrische Gerät ist denkbar, dass die Auswerteeinheit lediglich ein logischer Bestandteil einer im oder auf dem elektrischen Gerät vorhandenen CPU ist. Werden die Sensorsignale bereits als eine ausgewertete charakteristische Magnetisierung weitergegeben, so können diese ebenfalls in der Auswerteeinheit des elektrischen Geräts ausgewertet werden.

In einer weiteren Ausführungsform ist die Auswerteeinheit des elektrischen Geräts zur Freischaltung und/oder Sperrung von Funktionen des elektrischen Geräts ausgebildet. Die Auswerteeinheit des elektrischen Geräts kann also beispielsweise so ausgebildet sein, dass bei Abwesenheit der Abdeckvorrichtung entsprechende Funktionen des elektrischen Geräts gesperrt werden. Analog können bei Anwesenheit der Abdeckvorrichtung entsprechende Funktionen des elektrischen Geräts freigeschaltet werden. Auch hier gilt, dass die Auswerteeinheit in eine vorhandene CPU integriert sein kann.

Im Folgenden wird die Erfindung anhand der in den Figuren dargestellten Ausführungsbeispiele näher beschrieben und erläutert. Es zeigen:
- FIG 1: ein Gehäuse mit einer Abdeckvorrichtung und einer Vorrichtung,
- FIG 2: eine Abdeckvorrichtung,
- FIG 3: ein weiteres Gehäuse mit einer Abdeckvorrichtung und einer Vorrichtung und
- FIG 4: eine Magnetfeldsensoranordnung.

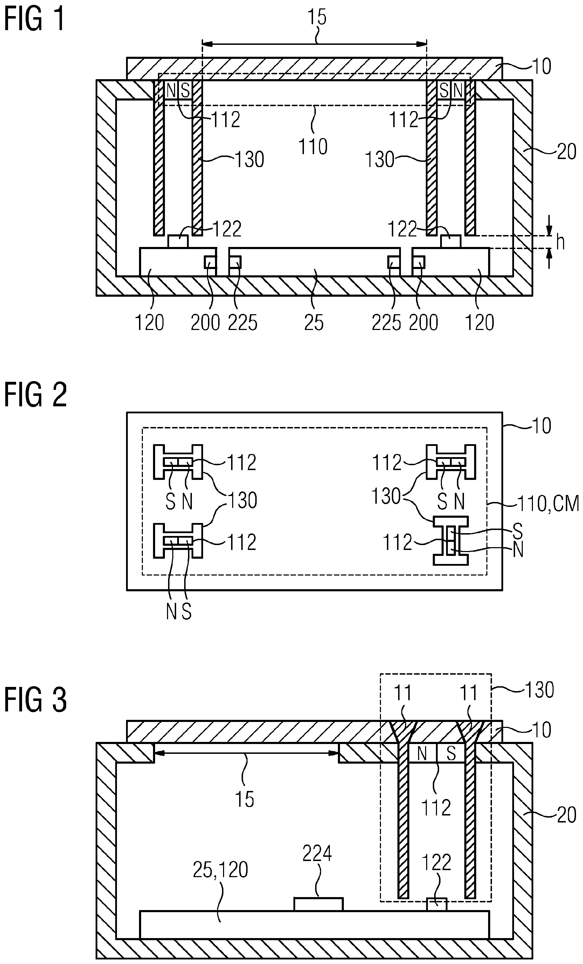

FIG 1 zeigt eine Ausführungsform einer Vorrichtung zur Detektion eines Öffnungsvorganges einer Abdeckvorrichtung 10 in einem Gehäuse 20, das eine Öffnung 15 aufweist und mit der Abdeckvorrichtung 10 verschlossen ist. Im Gehäuse 20 befindet sich ein elektrisches Gerät 25 mit zwei Schnittstellen 225. Die Vorrichtung weist dabei eine Magnetanordnung 110 mit zwei Permanentmagneten 112 auf. Die Permanentmagnete 112 mit jeweils einem Nordpol N und einem Südpol S sind in dieser Ausführungsform jeweils innerhalb einer Magnetfeldführungsanordnung 130 angeordnet. Die Magnetfeldführungsanordnung 130 führt das Magnetfeld der Permanentmagnete 112 jeweils zu einer Magnetfeldsensoranordnung 120 und damit in den Erfassungsbereich des Magnetfeldsensors 122. Die beiden Magnetfeldführungsanordnungen 130 sind dabei idealerweise aus einem weichmagnetischen Werkstoff gefertigt, d.h. ein ferromagnetisches Material mit hoher magnetischer Permeabilität und geringer Remanenz. Es handelt sich also um sogenannte magnetische Leiter. Auf diese Weise ist sichergestellt, dass das Magnetfeld der Permanentmagnete 112 entsprechend in den Erfassungsbereich der Magnetfeldsensoren 122 weitergeleitet wird. Jede der Magnetfeldführungsanordnungen 130 führt dabei das Magnetfeld des darin befindlichen Permanentmagents 112 in den Erfassungsbereich des zugeordneten Magnetfeldsensors 122. Dazu können die Magnetfeldführungsanordnungen 130 beispielsweise wie in FIG 1 dargestellt jeweils einen Schenkel pro Pol N, S des Permanentmagnets 112 aufweisen. Die Magnetfeldführungsanordnung 130 kann dabei am Gehäuse 20 oder an der Abdeckvorrichtung 10 befestigt sein. Für die Funktion der Vorrichtung ist es dabei relevant, dass bei einem Entfernen der Abdeckvorrichtung 10 das Magnetfeld nicht mehr in den Erfassungsbereich der Magnetfeldsensoranordnung 120 gelangt. Dies kann dadurch geschehen, dass die Magnetfeldführungsanordnungen 130 mit der Abdeckvorrichtung 10 entfernt werden und damit das Magnetfeld nicht mehr weitergeleitet wird. Alternativ können auch nur die Magnete 112 mit der Abdeckvorrichtung 10 entfernt werden. Auch eine Lösung in der sowohl die Magnetanordnungen 110 als auch die Magnetfeldführungsanordnungen 130 ein Teil der Abdeckvorrichtung 10 sind ist denkbar. Der Permanentmagnet 112 kann in die Magnetfeldführungsanordnung 130 integriert sein oder davon getrennt befestigt sein. Der Abstand h zwischen der Magnetfeldsensoranordnung 120 und der Magnetfeldführungsanordnung 130 stellt dabei sicher, dass trotz Fertigungs- und Montagetoleranzen im geschlossenen Zustand des Gehäuses 20 keine Beschädigungen der Magnetfeldsensoranordnung 120 oder des elektrischen Geräts 25 eintreten und trotzdem das Magnetfeld der Permanentmagnete 112 in den Erfassungsbereich der Magnetfeldsensoren 122 geführt wird. Das elektrische Gerät 25 ist dabei nur schematisch dargestellt. Die Schnittstellen 225 des elektrischen Geräts 25 sind dabei so ausgebildet, dass sie mit den Schnittstellen 200 der Magnetfeldsensoranordnungen 120 kommunizieren können. Dabei kann es sich um einfache Steckverbindungen handeln, es können dabei aber auch Schnittstellen, wie USB, optische oder Netzwerkschnittstellen verwendet werden.

FIG 2 zeigt eine Abdeckvorrichtung 10 mit einer Magnetanordnung 110, wobei die Magnetanordnung 110 aus vier Permanentmagneten 112 besteht. Jeder Permanentmagnet 112 weist des Weiteren eine Magnetfeldführungsanordnung 130 auf. Die Permanentmagnete 112 weisen jeweils einen Südpol S und einen Nordpol N auf, die Richtung der Magnetsierung der Permanentmagnete 112 ergibt eine charakteristische Magnetisierung CM der Magnetanordnung 110. Die Richtung der Magnetisierung, d.h. das Anordnen der Südpole S und der damit korrespondierenden Nordpole N, der Permanentmagnete 112 kann dabei völlig frei festgelegt werden und es ergeben sich so entsprechend viele Kombinationen und charakteristische Magnetisierungen CM.

FIG 3 zeigt ein Gehäuse 20 unter Beibehaltung der Bezugszeichen aus FIG 1. Dabei ist die Magnetfeldführungsanordnung 130 als zwei Befestigungsmittel 11 ausgebildet. Die Befestigungsmittel 11 leiten das Magnetfeld des Permanentmagnets 112 an den Magnetfeldsensor 122 weiter. Sollte nun also eines der Befestigungsmittel 11 entfernt werden, so ändert sich sofort das Magnetfeld und ein Eindringen in das Gehäuse 20 kann erkannt werden. Des Weiteren ist zu sehen, dass die Magnetfeldsensoranordnung 120 und das elektrische Gerät 25 als eine Einheit ausgebildet sind. Dies ist eine Ausgestaltung der Vorrichtung, die es bei einer geforderten höheren Integrationsdichte ermöglicht, die Magnetfeldsensoranordnung 120 und das elektrische Gerät 25 zu vereinen. Für die Auswertung der Signale des Magnetsensoranordnung 120 und der Magnetsensors 122 weist das elektrische Gerät 25 eine Auswerteeinheit 224 auf. Die Schnittstellen, die hier nicht gezeigt sind, können bspw. als interne Schnittstellen ausgeführt sein.

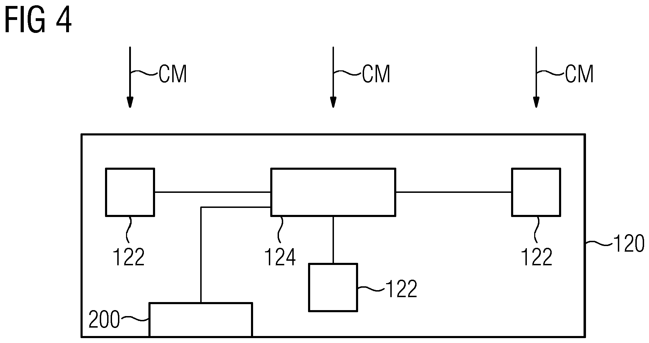

FIG 4 zeigt eine Magnetfeldsensoranordnung 120, mit drei Magnetfeldsensoren 122, einer Auswerteeinheit 124 und einer Schnittstelle 200. Mit den Pfeilen ist die charakteristische Magnetisierung CM angedeutet. Die Auswerteeinheit 124 erhält also die Signale von den Magnetfeldsensoren 122 und kann so die charakteristische Magnetisierung CM auswerten. Über die Schnittstelle 200 kann die charakteristische Magnetisierung CM oder eine darauf basierende Information, wie ein Freischaltsignal oder ein Sperrsignal, an das elektrische Gerät 25, das hier nicht dargestellt ist, weitergegeben werden.

Zusammenfassend betrifft die Erfindung eine Vorrichtung zur Detektion eines Öffnungsvorganges einer Abdeckvorrichtung 10, wobei die Abdeckvorrichtung 10 zum Abdecken einer Öffnung 15 eines Gehäuses 20 ausgebildet ist und wobei das Gehäuse 20 zur Aufnahme der Vorrichtung und eines elektrischen Geräts 25 ausgebildet ist. Des Weiteren betrifft die Erfindung ein elektrisches Gerät 25, das zur Aufnahme im Gehäuse 20 ausgebildet ist. Um eine Vorrichtung der eingangs genannten Art zur Verfügung zu stellen, die eine zuverlässige Erkennung eines Öffnungsvorgangs ermöglicht wird vorgeschlagen, dass die Vorrichtung eine Magnetanordnung 110 und mindestens eine Magnetfeldsensoranordnung 120 aufweist, wobei die Magnetanordnung 110 mindestens einen Permanentmagnet 112 aufweist, wobei die Magnetfeldsensoranordnung 120 mindestens einen Magnetfeldsensor 122 aufweist, wobei die Magnetanordnung 110 und/ oder die Magnetfeldsensoranordnung 120 jeweils derart an der Abdeckvorrichtung 10 und/oder dem Gehäuse 20 angebracht sind, dass der Öffnungsvorgang von der Magnetsensoranordnung 120 erfassbar ist und wobei der Magnetfeldsensor 122 zur Erfassung der Richtung von Magnetfeldern ausgebildet ist.

## Patentansprüche

1. Vorrichtung zur Detektion eines Öffnungsvorganges einer Abdeckvorrichtung (10), wobei die Abdeckvorrichtung (10) zum Abdecken einer Öffnung (15) eines Gehäuses (20) ausgebildet ist und wobei das Gehäuse (20) zur Aufnahme der Vorrichtung und eines elektrischen Geräts (25) ausgebildet ist,
**dadurch gekennzeichnet, dass**
die Vorrichtung eine Magnetanordnung (110) und mindestens eine Magnetfeldsensoranordnung (120) aufweist,
wobei die Magnetanordnung (110) mindestens einen Permanentmagnet (112) aufweist,
wobei die Magnetfeldsensoranordnung (120) mindestens einen Magnetfeldsensor (122) aufweist,
wobei die Magnetanordnung (110) und/oder die Magnetfeldsensoranordnung (120) jeweils derart an der Abdeckvorrichtung (10) und/oder dem Gehäuse (20) angebracht sind, dass der Öffnungsvorgang von der Magnetsensoranordnung (120) erfassbar ist und wobei der Magnetfeldsensor (122) zur Erfassung der Richtung von Magnetfeldern ausgebildet ist,wobei die Vorrichtung ferner mindestens eine Magnetfeldführungsanordnung (130) aufweist, die im geschlossenen Zustand der Abdeckvorrichtung (10) zur Führung des Magnetfeldes der Magnetanordnung (110) in einen Erfassungsbereich der Magnetsensoranordnung (120) ausgebildet ist und wobei die Magnetfeldführungsanordnung (130) als ein oder mehrere Befestigungsmittel (11) ausgebildet ist, wobei das/die Befestigungsmittel (11) zur Befestigung der Abdeckvorrichtung (10) am Gehäuse (20) vorgesehen und so ausgebildet ist/sind, dass mit dem Verschließen des Gehäuses durch die Abdeckvorrichtung das Magnetfeld der Magnetanordnung an die Magnetfeldsensoranordnung weiterleitet wird.

2. Vorrichtung nach Anspruch 1, wobei die Magnetfeldsensoranordnung (120) eine Schnittstelle (200) zum elektrischen Gerät (25) aufweist.

3. Vorrichtung nach einem der vorhergehenden Ansprüche, wobei die Magnetfeldsensoranordnung (120) ein Teil des elektrischen Geräts (25) ist.

4. Vorrichtung nach einem der vorhergehenden Ansprüche, wobei die Magnetfeldführungsanordnung (130) als ein Teil der Abdeckvorrichtung (10) ausgebildet ist.

5. Vorrichtung nach einem der vorhergehenden Ansprüche , wobei die Befestigungsmittel (11) derart ausgebildet sind, dass sie von außerhalb des Gehäuses (20) nicht lösbar, insbesondere nicht zerstörungsfrei lösbar, sind.

6. Vorrichtung nach einem der vorhergehenden Ansprüche, wobei die Magnetfeldsensoranordnung (120) zur Erfassung einer charakteristischen Magnetisierung (CM) der Magnetanordnung (110) ausgebildet ist.

7. Vorrichtung nach einem der vorhergehenden Ansprüche, wobei die Magnetfeldsensoranordnung (120) eine Auswerteeinheit (124) aufweist, die zur Auswertung einer charakteristischen Magnetisierung (CM) und/oder zur Weitergabe der charakteristischen Magnetisierung (CM) oder einer darauf basierenden Information an das elektrische Gerät (25) über die Schnittstelle (200) ausgebildet ist.

8. Vorrichtung nach einem der vorhergehenden Ansprüche, wobei die Magnetfeldsensoranordnung (120) eine Auswerteeinheit (124) aufweist, die zur Generierung eines Freischalt- und/oder Sperrsignals zur Freischaltung und/oder Sperrung von Funktionen des elektrischen Geräts (25) ausgebildet ist.

9. Elektrisches Gerät (25) ausgebildet zur Aufnahme in einem Gehäuse (20) aufweisend eine Schnittstelle (225) zu einer Vorrichtung nach einem der vorhergehenden Ansprüche.

10. Elektrisches Gerät nach Anspruch 9, aufweisend eine Auswerteeinheit (224), wobei die Auswerteeinheit (224) des elektrischen Geräts (25) zur Auswertung einer charakteristischen Magnetisierung (CM) und/oder eine auf der charakteristischen Magnetisierung (CM) basierenden weiteren Information ausgebildet ist.

11. Elektrisches Gerät nach Anspruch 10, wobei die Auswerteeinheit (224) zur Freischaltung und/oder Sperrung von Funktionen des elektrischen Geräts (25) ausgebildet ist.

## Claims

1. Device for the detection of an opening process of a covering device (10), wherein the covering device (10) is designed to cover an opening (15) of a housing (20) and wherein the housing (20) is designed to accommodate the device and an electrical device (25),
**characterised in that**
the device has a magnet arrangement (110) and at least one magnetic field sensor arrangement (120),
wherein the magnet arrangement (110) has at least one permanent magnet (112),
wherein the magnetic field sensor arrangement (120) has at least one magnetic field sensor (122),
wherein the magnet arrangement (110) and/or the magnetic field sensor arrangement (120) are each attached to the covering device (10) and/or the housing (20) such that the opening process can be detected by the magnetic sensor arrangement (120) and wherein the magnetic field sensor (122) is designed to detect the direction of magnetic fields, wherein the device further has at least one magnetic field guide arrangement (130) which in the closed state of the covering device (10) is designed to guide the magnetic field of the magnet arrangement (110) into a detection range of the magnetic sensor arrangement (120) and wherein the magnetic field guide arrangement (130) is designed as one or more fasteners (11),
wherein the one or more fasteners (11) are provided for fastening the covering device (10) to the housing (20) and are designed such that when the housing is closed by the covering device the magnetic field of the magnet arrangement is relayed to the magnetic field sensor arrangement.

2. Device according to claim 1, wherein the magnetic field sensor arrangement (120) has an interface (200) to the electrical device (25).

3. Device according to one of the preceding claims, wherein the magnetic field sensor arrangement (120) is part of the electrical device (25).

4. Device according to one of the preceding claims, wherein the magnetic field guide arrangement (130) is designed as part of the covering device (10).

5. Device according to one of the preceding claims, wherein the fasteners (11) are designed such that they are non-releasable from outside the housing (20), in particular not non-destructively releasable.

6. Device according to one of the preceding claims, wherein the magnetic field sensor arrangement (120) is designed to detect a characteristic magnetisation (CM) of the magnet arrangement (110).

7. Device according to one of the preceding claims, wherein the magnetic field sensor arrangement (120) has an evaluation unit (124) which is designed to evaluate a characteristic magnetisation (CM) and/or to relay the characteristic magnetisation (CM) or information based thereon to the electrical device (25) via the interface (200).

8. Device according to one of the preceding claims, wherein the magnetic field sensor arrangement (120) has an evaluation unit (124) which is designed to generate an activation signal and/or a blocking signal for activating and/or blocking functions of the electrical device (25).

9. Electrical device (25) designed to be accommodated in a housing (20) having an interface (225) to a device according to one of the preceding claims.

10. Electrical device according to claim 9, having an evaluation unit (224), wherein the evaluation unit (224) of the electrical device (25) is designed to evaluate a characteristic magnetisation (CM) and/or further information based on the characteristic magnetisation (CM).

11. Electrical device according to claim 10, wherein the evaluation unit (224) is designed to activate and/or block functions of the electrical device (25).

## Revendications

1. Dispositif de détection d'une opération d'ouverture d'un dispositif (10) de recouvrement, le dispositif (10) de recouvrement étant constitué pour recouvrir une ouverture (15) d'un boîtier (20) et le boîtier (20) étant constitué pour recevoir le dispositif et un appareil (25) électrique, **caractérisé en ce que**
le dispositif a un système (110) d'aimant et au moins un système (120) de capteur de champ magnétique,
dans lequel le système (110) d'aimant a au moins un aimant (112) permanent,
dans lequel le système (120) de capteur de champ magnétique a au moins un capteur (122) de champ magnétique,
dans lequel le système (110) d'aimant et/ou le système (120) de capteur de champ magnétique sont mis chacun sur le dispositif (10) de recouvrement et/ou le boîtier (20) de manière à ce que l'opération d'ouverture puisse être détectée par le système (120) de capteur magnétique et dans lequel le capteur (122) de champ magnétique est constitué pour la détection de la direction de champs magnétiques et dans lequel le dispositif a, en outre, au moins un système (130) de guidage de champ magnétique, qui, lorsque le dispositif (10) de recouvrement est à l'état fermé, est constitué pour guider le champ magnétique du système (110) d'aimant dans une région de détection du système (120) de capteur magnétique, et dans lequel le système (130) de guidage de champ magnétique est constitué sous la forme d'un ou de plusieurs moyens (11) de fixation, le/les moyen (s) (11) de fixation étant prévu (s) pour fixer le dispositif (10) de recouvrement au boîtier (20) et est/sont constitué (s) de manière à ce que, par la fermeture du boîtier par le dispositif de recouvrement, le champ magnétique du système d'aimant est acheminé au système de capteur de champ magnétique.

2. Dispositif suivant la revendication 1, dans lequel le système (120) de capteur de champ magnétique a une interface (200) avec l'appareil (25) électrique.

3. Dispositif suivant l'une des revendications précédentes, dans lequel le système (120) de capteur de champ magnétique fait partie de l'appareil (25) électrique.

4. Dispositif suivant l'une des revendications précédentes, dans lequel le système (130) de guidage de champ magnétique est constitué sous la forme d'une partie du dispositif (10) de recouvrement.

5. Dispositif suivant l'une des revendications précédentes, dans lequel les moyens (11) de fixation sont constitués de manière à ne pas pouvoir être détachés, notamment à ne pas pouvoir être détachés sans destruction, de l'extérieur du boîtier (20).

6. Dispositif suivant l'une des revendications précédentes, dans lequel le système (120) de capteur de champ magnétique est constitué pour la détection d'une aimantation (CM) caractéristique du système (110) d'aimant.

7. Dispositif suivant l'une des revendications précédentes, dans lequel le système (120) de capteur de champ magnétique a une unité (124) d'exploitation, qui est constituée pour l'exploitation d'une aimantation (CM) caractéristique et/ou pour la retransmission de l'aimantation (CM) caractéristique ou d'une information fondée sur celle-ci vers l'appareil (25) électrique par l'intermédiaire de l'interface (200).

8. Dispositif suivant l'une des revendications précédentes, dans lequel le système (120) de capteur de champ magnétique a une unité (124) d'exploitation, qui est constituée pour la production d'un signal de libération et/ou d'un signal de blocage pour libérer et/ou bloquer des fonctions de l'appareil (25) électrique.

9. Appareil (25) électrique constitué pour être reçu dans un boîtier (20) comportant une interface (225) avec un dispositif suivant l'une des revendications précédentes.

10. Appareil électrique suivant la revendication 9, comportant une unité (224) d'exploitation, l'unité (224) d'exploitation de l'appareil (25) électrique étant constituée pour l'exploitation d'une aimantation (CM) caractéristique et/ou d'une autre information reposant sur l'aimantation (CM) caractéristique.

11. Appareil électrique suivant la revendication 10, dans lequel l'unité (224) d'exploitation est constituée pour la libération et/ou le blocage de fonctions de l'appareil (25) électrique.
